# EUROPEAN PATENT APPLICATION

(11) **EP 4 791 124 A1**
(43) Date of publication of application: **12.08.2026**
(21) Application number: 24874490.6
(22) Date of filing: 20.09.2024
(51) Int. Cl.: H05K 3/00, H01L 23/12, H05K 1/03

(54) **METHOD FOR MANUFACTURING CERAMIC SCRIBE SUBSTRATE, METHOD FOR MANUFACTURING CERAMIC SUBSTRATE, AND METHOD FOR MANUFACTURING CERAMIC CIRCUIT BOARD**

(30) Priority: 05.10.2023 JP 2023173734
(71) Applicant: Niterra Materials Co., Ltd., Yokohama-shi, Kanagawa 235-0032 (JP)
(72) Inventor: HOSHINO, Naoto, Yokohama-shi, Kanagawa 2350032 (JP)
(74) Representative: Hoffmann Eitle
(86) International application number: PCT/JP2024/033572
(87) International publication number: WO 2025/074881

(57) **Abstract**

A production method for a ceramic scribe substrate including a ceramic substrate as an element according to embodiments, includes a laser processing step and a removal step. The laser processing step forms a continuous through-groove as a scribe line and forms a removal portion surrounded by multiple scribe lines, by irradiating a front surface of a sintered ceramic substrate with a laser. The removal step removes the removal portion by jetting an assist gas coaxially with the laser, during the irradiation with the laser.

## Description

### TECHNICAL FIELD

Embodiments mainly relate to a production method for a ceramic scribe substrate, a production method for a ceramic substrate, and a production method for a ceramic circuit substrate.

### BACKGROUND ART

With the development of semiconductor devices requiring large current, as exemplified by power electronics and next-generation power semiconductors, the demand for a ceramic substrate having both heat dissipation and electric insulation has increased every year. Particularly, as the heat generation of devices increases with decrease in size and increase in performance, the thickness of the ceramic substrate tends to become smaller for efficiently performing heat release.

Meanwhile, for decreasing the production cost of the ceramic substrate, sintered ceramic substrates that are plate-shaped sintered ceramic compounds including multiple ceramic substrates as elements have been produced. Among sintered ceramic substrates, as a silicon nitride substrate that is obtained from a sintered silicon nitride substrate having both of high strength and toughness and high heat dissipation, there has been disclosed a silicon nitride substrate having a size in which the length × width of front and back surfaces is 220 mm × 220 mm and the thickness is 0.32 mm (Patent Document 1).

As one method for dividing a large sintered silicon nitride substrate produced for decreasing the production cost, into silicon nitride substrates having a product size for use, there has been disclosed a method in which many silicon nitride substrates are taken from the sintered silicon nitride substrate using scribe lines formed on the sintered silicon nitride substrate by laser processing (Patent Document 2). According to Patent Document 2, after the division (break) with the taking of many silicon nitride substrates by laser processing, microcracks are not unnecessarily generated on the silicon nitride substrates, and the scribe line processing for taking many silicon nitride substrates can be easily performed at low cost.

Further, there has been disclosed a method in which air is used as an assist gas when laser processing is performed to the sintered ceramic substrate (Patent Document 3). According to Patent Document 3, by a scribe line that is formed by a through-groove by a laser, a chamfered portion can be formed on the ceramic substrate after the division.

Further, there has been disclosed a method in which a chamfer is formed on the sintered ceramic substrate by laser processing (Patent Document 4). According to Patent Document 4, a burr evaporated by a laser can be embrittled and removed by oxidization and cooling actions of the assist gas.

### PRIOR ART DOCUMENTS

### PATENT DOCUMENT

Patent Document 1: Japanese Patent No. 6399252
Patent Document 2: Japanese Patent Laid-Open No. 2002-176119
Patent Document 3: Japanese Patent Laid-Open No. 5-144978
Patent Document 4: Japanese Patent Laid-Open No. 2008-198905

### SUMMARY OF THE INVENTION

### PROBLEMS TO BE SOLVED BY THE INVENTION

Problems caused by the increase in the size of the front and back surfaces of the sintered ceramic substrate and the decrease in the thickness for improving productivity have been revealed. For example, in the case where the scribe line is formed on the sintered ceramic substrate having high strength and high toughness by the laser, the scribe line is sometimes formed deeply in a thickness direction. This is because the sintered ceramic substrate has high strength and therefore a great force is necessary for performing the division along the scribe line.

However, when the thickness of the sintered ceramic substrate is small, the scribe line becomes a through-groove or becomes substantially a through-groove, and therefore, there is a high possibility that a portion (that is, a portion corresponding to a "removal portion" described later) formed by the scribe line is unintentionally dropped off by a force that is given at the time of a processing step (for example, a metal joining step) after the formation of the scribe line by the laser or at the time of conveyance. When the unintentional drop of the portion frequently occurs, the portion need to be collected in a subsequent step, and workload is generated. In contrast, when the laser is shallowly put in the thickness direction, there is a low possibility that the portion is dropped off in a middle step, but it is necessary to apply a great force at the time of the division along the scribe line. Therefore, it has been found that workload is generated and a defect (a breakage, a crack, and the like) due to the application of a great force is generated on the ceramic substrate.

That is, although the scribe line for the chamfered portion of the ceramic substrate can be formed on the sintered ceramic substrate by laser processing, a removal processing method for the scribe line needs to be controlled for improving the work efficiency for the division along the scribe line and the collection of the dropped portion and preventing the generation of the defect of the ceramic substrate.

A problem to be solved by the embodiment is to efficiently produce a ceramic scribe substrate, a ceramic substrate, and a ceramic circuit substrate, with no defect, from a high-strength thin sintered ceramic substrate that has both heat dissipation and electric insulation and that includes front and back surfaces having a large size.

### MEANS FOR SOLVING THE PROBLEMS

A production method for a ceramic scribe substrate including a ceramic substrate as an element according to embodiments, includes a laser processing step and a removal step. The laser processing step forms a continuous through-groove as a scribe line and forms a removal portion surrounded by multiple scribe lines, by irradiating a front surface of a sintered ceramic substrate with a laser. The removal step removes the removal portion by jetting an assist gas coaxially with the laser, during the irradiation with the laser.

### BRIEF DESCRIPTION OF THE DRAWINGS

[FIG. 1] FIG. 1 is a plan view showing an example of a front surface of a ceramic scribe substrate that is produced in a production method for a ceramic scribe substrate according to an embodiment.
[FIG. 2] FIG. 2 is a plan view showing an example of a front surface of a ceramic substrate that is produced in a production method for a ceramic substrate according to an embodiment.
[FIG. 3] FIG. 3 is an enlarged view showing a part of a back surface of the ceramic scribe substrate that is produced in the production method for the ceramic scribe substrate according to the embodiment.
[FIG. 4] FIG. 4 is an enlarged sectional view showing an example of the ceramic scribe substrate that is produced in the production method for the ceramic scribe substrate according to the embodiment.
[FIG. 5] FIG. 5 is a side view showing an example of a ceramic circuit substrate that is produced in a production method for a ceramic circuit substrate according to an embodiment.
[FIG. 6] FIG. 6 is a side view showing an example of the ceramic circuit substrate that is produced in the production method for the ceramic circuit substrate according to the embodiment and that is integrated by a resin mold.
[FIG. 7] FIG. 7 is a diagram showing the production method for the ceramic circuit substrate according to the embodiment, as a flowchart.

### DESCRIPTION OF EMBODIMENTS

Embodiments of a production method for a ceramic scribe substrate, a production method for a ceramic substrate, and a production method for a ceramic circuit substrate will be described below in detail with reference to the drawings.

The production method for the ceramic scribe substrate according to the embodiment includes a laser processing step and a removal step. In the laser processing step, a continuous through-groove is formed as a scribe line, and a removal portion surrounded by multiple scribe lines is formed, by irradiating a front surface of the sintered ceramic substrate with a laser. In the removal step, the removal portion is removed by jetting an assist gas coaxially with the laser, during the irradiation with the laser. It is preferable that the area of a front surface of a portion (a C-surface portion 44 that is cut by a C-surface 43 described later) of the removal portion per each ceramic substrate is 1.0 mm² or more and 20.0 mm² or less.

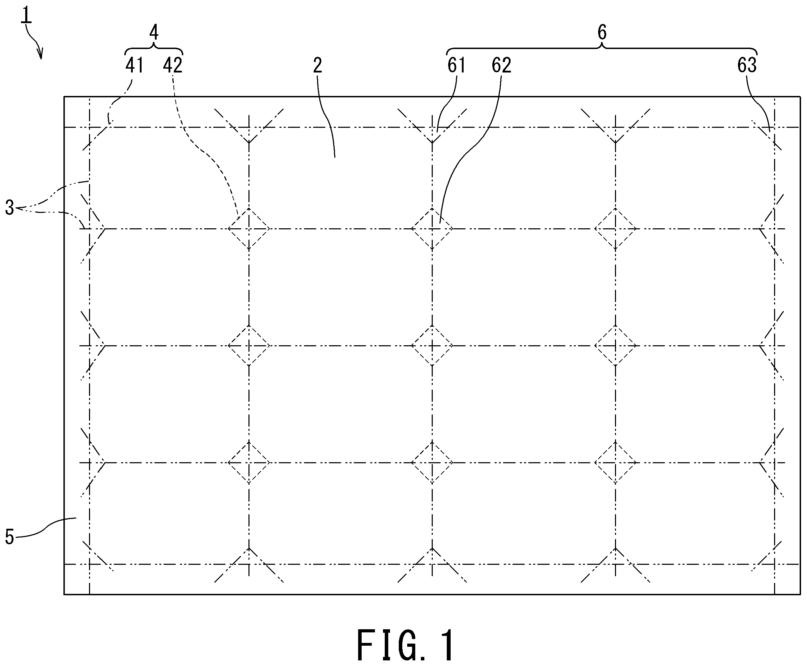

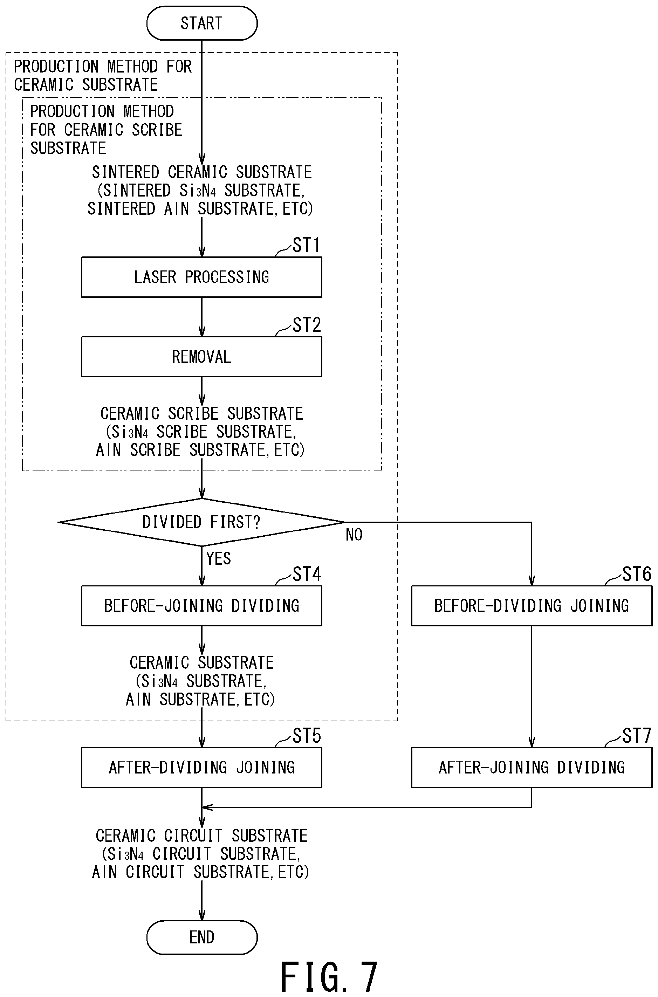

FIG. 1 is a top view showing an example of a front surface of a ceramic scribe substrate (abbreviated to "scribe substrate" hereinafter) 1 on which scribe lines are provided and that includes front and back surfaces having a rectangular shape (including a square). In the scribe substrate 1, scribe lines 3, 4 are provided on the sintered ceramic substrate that is a sintered ceramic compound having a plate shape. The scribe substrate 1 includes, as elements, multiple ceramic substrates 2 each of which is a product. In the example shown in FIG. 1, the scribe substrate 1 includes four sets in a longitudinal direction and four sets in a lateral direction, and includes a total of 16 ceramic substrates 2. FIG. 7 shows, as a flowchart, a production method for the scribe substrate 1 shown in FIG. 1, a production method for a ceramic substrate based on the scribe substrate 1, and a production method for a ceramic circuit substrate 8 based on the scribe substrate 1.

The scribe substrate 1 includes a peripheral portion 5 that is not a product, around the ceramic substrates 2. At a border between the ceramic substrates 2 and the peripheral portion 5 and a border between adjacent ceramic substrates 2, side scribe lines 3 (shown by two-dot lines in FIG. 1) are provided. Further, at four corners of each ceramic substrate 2, corner scribe lines 4 are provided for forming chamfers of the ceramic substrate 2. One end of an outer corner scribe line 41 (shown by a one-dot chain line in FIG. 1) of the corner scribe lines 4 that contacts with the peripheral portion 5 is formed so as to extend to an interior of the peripheral portion 5. On the other hand, one end of an inner corner scribe line 42 (shown by a broken line in FIG. 1) of the corner scribe lines 4 that contacts with an adjacent ceramic substrate 2 does not extend to an interior of the adjacent ceramic substrate 2.

The scribe substrate 1 is in a state where the scribe lines 3, 4 have been formed. Further, the removal of removal portions 6 described later is performed during the irradiation with the laser for the formation of the scribe lines 3, 4, and therefore, the scribe substrate 1 is in a state where the removal portions 6 have been removed. In FIG. 1, the removal portions 6 includes first removal portions 61 (12 portions in the example in FIG. 1) each of which is formed by one side scribe line 3 and two outer corner scribe lines 41 and has a triangular shape, second removal portions 62 (9 portions in the example in FIG. 1) each of which is formed by four inner corner scribe lines 42 and has a quadrangular shape, and third removal portions 63 (4 portions in the example in FIG. 1) each of which is formed by two side scribe lines 3 and one outer corner scribe line 41 and has a triangular shape. The removal portion 6 is a region surrounded by lines of a continuous through-groove (which passes in a sheet-plane depth direction in FIG. 1, that is, in a thickness direction) that is formed by the laser.

The scribe substrate 1 is not limited to the case shown in FIG. 1. For example, the scribe substrate 1 may include only one ceramic substrate 2 as an element, or may include three or more ceramic substrates 2 longitudinally and laterally, as elements. Further, the side scribe line 3 does not need to be formed at all of the four sides of the ceramic substrate 2, and the side scribe line 3 only needs to be formed at one or more sides. Further, the ceramic substrate 2 has an oblong shape in the plan view of FIG. 1, but may have a roughly polygonal shape. Further, the chamfered portion does not need to be formed at all of the four corners of the ceramic substrate 2, and only needs to be provided at one or more corners.

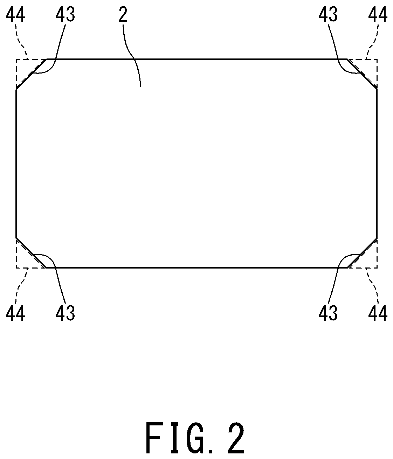

FIG. 2 shows one of the plurality of ceramic substrates 2 into which the scribe substrate 1 shown in FIG. 1 is divided. At the four corners of the ceramic substrate 2, C-surfaces 43 are formed by chamfering along the corner scribe lines 4 in FIG. 1. The chamfered portion is not limited to the C-surface 43 that has a straight line as a line viewed from the front surface, and may have an R-surface that has a curve line as a line viewed from the front surface. In the case where the chamfered portion have an R-surface, the corner scribe line 4 also has a curve line as a line viewed from the front surface, and the surface 43 side of the portion 44 constituting the removal portion 6 also has a curve line as a line viewed from the front surface.

In a laser processing step ST1 (shown in FIG. 7) of forming scribe lines 3, 4 on the sintered ceramic substrate and forming the removal portions 6, lines of the continuous through-groove can be formed by the laser. The lines of the continuous through-groove means that a part of each of through-grooves that are discontinuously formed overlaps with a part of an adjacent through-groove when the scribe substrate 1 is viewed from the front surface. As the kind of the laser, a laser having a wavelength of 532 nm or more is preferable. This is because the laser is easily absorbed by the front surface of the ceramic substrate when the wavelength of the laser is larger than 532 nm. As the laser having a wavelength of 532 nm or more, there are a YAG laser (a fundamental harmonic or a second order harmonic), an eximer laser, a fiber laser, a CO₂ laser, and the like. Further, it is preferable that the oscillation of the laser is continuous oscillation or pulsed oscillation. In the case of the pulsed oscillation, it is preferable that the pulse width is picoseconds or femtoseconds. When the pulse width is short, heat affect is small, and therefore, high-precision microfabrication can be performed. Therefore, it is further preferable that the kind of the laser is the fiber laser.

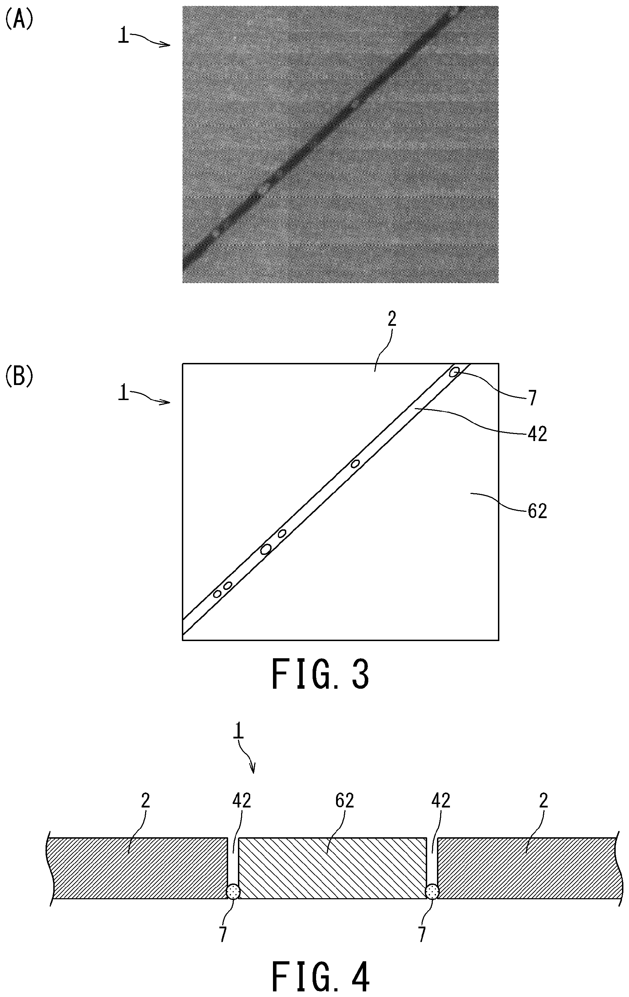

When the through-groove is made, molten material (dross) remains in the through-groove due to the laser. Fig. 3 is an example of an enlarged view showing a part of the back surface of the scribe substrate 1. Division (A) of FIG. 3 is an enlarged photograph showing a part of the back surface of the scribe substrate 1. Division (B) of FIG. 3 is a diagram schematically illustrating Division (A) of FIG. 3. Reference Numeral 7 denotes the molten material. FIG. 4 is an example of a cross-section of a part of the ceramic scribe substrate 1. In some cases, the molten material 7 exists in the corner scribe line 4 (for example, the inner corner scribe line 42), and thereby, the ceramic substrate 2 and the removal portion 6 (for example, the second removal portion 62) are partially welded, so that the second removal portion 62 cannot be removed in the laser processing step ST1. The molten material 7 partially exists and is fragile, and therefore, there is a fear that the second removal portion 62 remaining on the scribe substrate in the laser processing step ST1 is unintentionally dropped off from the scribe substrate in a step after the laser processing step ST1.

Therefore, the production method for the scribe substrate 1 according to the embodiment includes a removal step ST2 (shown in FIG. 7) of blowing and removing the removal portion 6 by jetting an assist gas coaxially with the laser, during the irradiation with the laser in the laser processing step ST1. Generally, for the purpose (that is, a molten material discharge purpose) of generating oxidation reaction heat and discharging the molten material 7 from the through-groove, an assist gas such as nitrogen and air is jetted to the molten material 7 in the laser processing step ST1. In the removal step ST2 in which the jetting mechanism is utilized, jetting the assist gas coaxially with the laser is utilized also for the purpose of the removal of the removal portion 6, and the assist gas is strongly thrown against an edge surface and front surface of the removal portion 6, so that the removal portion 6 is blown. By this removal step ST2, it is not necessary to separately provide another mechanism for the purpose of the removal of the removal portion 6.

In the removal step ST2, the remaining removal portion 6 may be removed by jetting the assist gas after the irradiation with the laser, in addition to during the irradiation with the laser. For example, during the irradiation with the laser for forming each of adjacent through-grooves that constitute the continuous through-groove, the assist gas is jetted for the purpose of the removal of the removal portion 6, and therewith, in a period (that is, a period of non-irradiation with the laser) after the irradiation of the former through-groove and before the irradiation of the latter through-groove, the assist gas is jetted to the former through-groove for the purpose of the removal.

The jetting pressure of the assist gas for removing the removal portion 6 may be intentionally altered between the laser processing step ST1 and the removal step ST2. For example, the jetting pressure of the assist gas may be increased in the removal step ST2, compared to the laser processing step ST1. When the assist gas is jetted at a higher pressure in the removal step ST2 than that in the laser processing step ST1 for blowing the removal portion 6 by the assist gas, the removal of the removal portion 6 is smoothly performed. On this occasion, in the case where the alteration of the jetting pressure is complicated or in the case where the alteration amount is excessively large, it is preferable to increase the jetting pressure of the assist gas in the laser processing step ST1 and adjust the balance of the jetting pressure with the removal step ST2.

In the removal step ST2, the assist gas may be jetted for the purpose of the removal of the removal portion 6, at both of the time of the formation of the side scribe line 3 and the time of the formation of the corner scribe line 4, but the assist gas may be jetted for the purpose of the removal of the removal portion 6, only at the time of the formation of the corner scribe line 4. This is because the lines that form the removal portion 6 includes at least one corner scribe line 4. The first removal portion 61 is formed by two corner scribe lines 4, the second removal portion 62 is formed by four corner scribe lines 4, and the third removal portion 63 is formed by one corner scribe line 4. In the removal step ST2, the removal portion 6 is removed by jetting the assist gas coaxially with the laser, during the irradiation with the laser in the case of the formation of the corner scribe line 4 of the plurality of scribe lines 3, 4.

It is preferable that the jetting pressure of the assist gas in the removal step ST2 is 0.2 MPa or more and 1.0 MPa or less. When the jetting pressure is less than 0.2 MPa, there is a fear that the pressure is low and the removal portion 6 cannot be sufficiently removed. On the other hand, when the jetting pressure is more than 1.0 MPa, there is a fear that the position gap of the scribe substrate 1 is caused by the pressure of the assist gas. Further, when the jetting is performed from the front surface in the removal step ST2, it is preferable to perform dust collection by suction from the front surface or the back surface. By performing the suction together with the jetting, it is possible to remove dust that is generated by laser processing.

It is preferable that the area of a front surface of the C-surface portion 44 (shown in FIG. 2) of the removal portion 6 per each ceramic substrate 2 is 1.0 mm² or more and 20.0 mm² or less. When the area of the C-surface portion 44, that is, the front surface of the removal portion 6 is excessively small, the space of the through-groove becomes small. Therefore, there is a possibility that, even when the assist gas is jetted, the removal portion 6 is obliquely positioned, the assist gas is caught by an inner wall of the through-groove, and the removal portion 6 does not successfully get away or the external appearance becomes poor. On the other hand, when the removal portion 6 is excessively large, there is a possibility that the jetting pressure becomes insufficient and the removal portion 6 cannot be blown and removed. Therefore, a more preferable range of the front surface size of the C-surface portion 44 is 2.0 mm² or more and 10.0 mm² or less. Further, the removal of the removal portion 6 is performed by providing a hole portion on a table for the laser processing, jetting the assist gas downward when a laser processing surface is at an upper portion, and dropping the removal portion 6 to a lower portion.

It is preferable that the shape of the front surface of the removal portion 6 is a simple shape. Examples of the shape surrounded by through-grooves include a circularly hollowed shape (through-hole) and a rectangular shape such as a square. When the front surface of the removal portion 6 has a complex shape, there is a possibility that the removal portion 6 is caught and cannot be smoothly removed in the removal step ST2.

It is preferable that the sintered ceramic substrate, that is, the scribe substrate 1 and the ceramic substrate 2 are one kind of a silicon nitride substrate, an aluminum nitride substrate, and an aluminum oxide substrate. Further, an Alusil substrate is also included as one kind of the aluminum oxide substrate. Alusil is a sintered compound that contains 20-80 wt% aluminum oxide and contains zirconium oxide as the remnant. The three-point bending strength of the aluminum nitride substrate or the aluminum oxide substrate is about 300-450 MPa. The strength of the Alusil substrate is around 550 MPa. The three-point bending strength of the silicon nitride substrate can be increased to 600 MPa or more, furthermore, to 700 MPa or more. The heat conductivity of the silicon nitride substrate can be increased to 50 W/m·K or more, furthermore, to 80 W/m·K or more. In recent years, there is a silicon nitride substrate that has both of high strength and high heat conductivity.

It is preferable that the sintered ceramic substrate is a substrate that is divided into multiple ceramic substrates 2. In the case where the sintered ceramic substrate is divided into multiple ceramic substrates 2, it is preferable that the front and back surfaces of the sintered ceramic substrate have a rectangular shape with a size in which a short side is 10 cm or more and a long side is 20 cm or more. As described above, when the size of the front and back surfaces of the sintered ceramic substrate to be processed is large, it is possible to obtain many ceramic substrates 2 from one scribe substrate 1. Therefore, it is possible to efficiently obtain the ceramic substrates 2 after the division.

In the assist gas, it is preferable that a sum of partial pressures of nitrogen or a noble gas is 70% or more. However, since nitrogen or the noble gas is expensive, air may be added. When the partial pressure of oxygen contained in the assist gas is more than 20%, there is a possibility that a front surface of the ceramic other than oxides is oxidized. Therefore, it is preferable that the partial pressure of oxygen is as low as 20% or less.

It is preferable that the thickness of the sintered ceramic substrate, that is, the thickness of the ceramic substrate 2 is a thickness of 0.1 mm or more and 2 mm or less. When the thickness is more than 2 mm, there is a possibility that the blowing by the assist gas cannot be performed. On the other hand, when the thickness is as thin as less than 0.1 mm, there is a possibility that a sufficient strength cannot be kept. A more preferable thickness of the ceramic substrate 2 is 0.2 mm or more and 1 mm or less. When the thickness of the ceramic substrate 2 is 0.2 mm or more and 1 mm or less, processing can be suitably performed with high efficiency while a sufficient strength is kept.

Furthermore, it is preferable that the obtained scribe substrate 1 is cleaned in a cleaning step of cleaning the front surface by horning, blasting, or the like, which is a step after the removal step ST2.

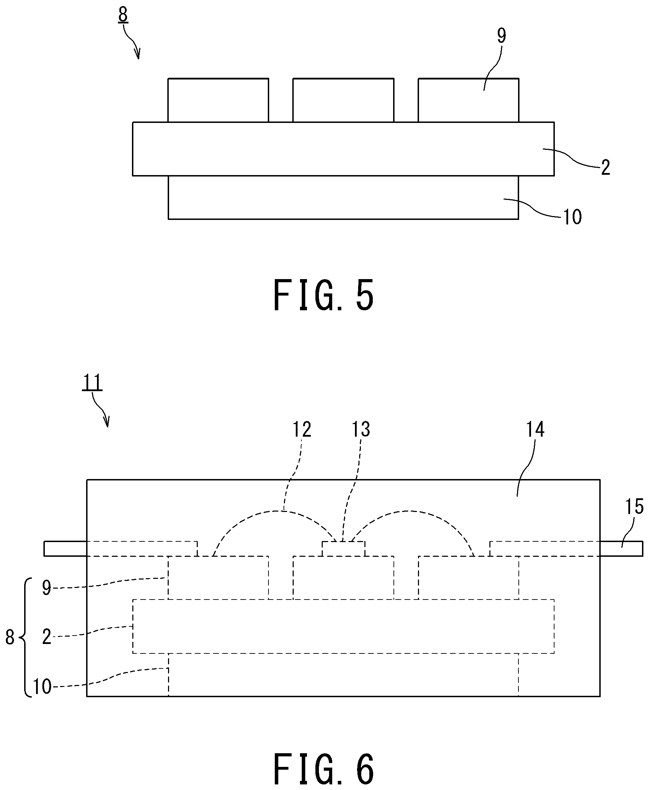

After the removal step ST2, in a before-joining dividing step ST4 (shown in FIG. 7), the scribe substrate 1 is divided, and the ceramic substrate 2 is obtained. Then, in an after-dividing joining step ST5 (shown in FIG. 7), a metallic circuit such as a metallic plate is joined to the ceramic substrate 2 after the division, and thereby, the ceramic circuit substrate can be formed. FIG. 5 shows an example of a ceramic circuit substrate 8 according to the embodiment. In FIG. 5, reference numeral 8 denotes a ceramic circuit substrate, reference numeral 2 denotes a ceramic substrate, reference numeral 9 denotes a metallic circuit, and reference numeral 10 denotes a metallic radiator plate.

As the metallic plate that is used for the metallic circuit 9, there are Cu (copper), a copper alloy, Al (aluminum) and the like. It is preferable that the ceramic substrate 2 and the metallic circuit 9 are joined through a joining layer (not illustrated). Also in the case where the metallic radiator plate 10 is joined, it is preferable that the metallic radiator plate 10 is joined to the ceramic substrate 2 through a joining layer. Further, it is preferable that the joining layer is provided between the ceramic substrate 2 and the metallic circuit 9 by an active metal brazing material containing an active metal such as Ti (titanium). As the active metal, there is Zr (zirconium), other than Ti. As the active metal brazing material, there is a mixture containing one kind of Ag (argentum) and Cu as a main component, other than Ti.

In the active metal brazing material, Ti is contained at 0.1 wt% or more and 10 wt% or less, Cu is contained at 10 wt% or more and 60 wt% or less, and the remnant is Ag. In the active metal brazing material, as necessary, one or more kinds selected from In (indium), Sn (tin), Al, Si (silicon), C (carbon), and Mg (magnesium) may be added at 1 wt% or more and 15 wt% or less. In an active metal joining method in which the active metal brazing material is used, an active metal brazing material paste is applied on the front surface of the ceramic substrate 2, the metallic circuit 9 is disposed thereon, and this is heated at 600°C or more and 900°C or less, so that joining is performed. By the active metal joining method, the joining strength between the ceramic substrate 2 and the metallic circuit 9 that is a copper circuit plate can become 16 kN/m or more.

On the front surface of the metallic circuit 9, a metallic thin film (not illustrated) containing, as a main component, one kind selected from Ni (nickel), Ag (argentum), and Au (aurum) may be provided. As the metallic thin film, there are a plating film, a sputtering film, and the like. By providing the metallic thin film on the front surface of the metallic circuit 9, it is possible to improve the corrosion resistance and solder wettability of the metallic circuit 9.

The method in which the ceramic circuit substrate 8 is produced by performing the division before the joining of the metallic circuit has been described, but the embodiment is not limited to the case. In a before-dividing joining step ST6 (shown in FIG. 7), before the division into the ceramic substrates 2, in the state of the scribe substrate 1 shown in FIG. 1, the metallic circuit 9 may be joined to the ceramic substrates 2, and in an after-joining dividing step ST7 (shown in FIG, 7), the ceramic circuit substrate 8 may be obtained by division. On this occasion, it is preferable that the metallic circuit 9 to be joined is a copper or aluminum member. When the kind of the metallic circuit 9 to be joined is a copper member or aluminum member, the heat conductivity is high, and therefore, the copper member or aluminum member is preferable. The copper member or aluminum member is a member composed of copper or a copper alloy or a member composed of aluminum or an aluminum member. Further, when the metallic circuit 9 is joined to the ceramic substrate 2, a conductor portion having a predetermined shape may be joined previously. In the case where the metallic circuit 9 is provided by joining in the before-dividing joining step ST6 of providing the metallic circuit 9, it is preferable that the joined metallic circuit 9 is subjected to etching, chemical grinding, or the like in a step after the before-dividing joining step ST6.

It is preferable that the ceramic circuit substrate 8 obtained in steps ST4 and ST5 and steps ST6 and ST7 is applied to a semiconductor module in which a semiconductor device is mounted on the metallic circuit 9 through a joining layer.

FIG. 6 shows an example of the semiconductor module (semiconductor equipment) according to the embodiment. In FIG. 6, reference character 8 denotes a ceramic circuit substrate, reference character 11 denotes a semiconductor module, reference character 12 denotes a bonding wire, reference character 13 denotes a semiconductor device, reference character 14 denotes a resin mold, and reference character 15 denotes a lead frame.

In FIG. 6, the semiconductor device 13 is joined on the metallic circuit 9 of the ceramic circuit substrate 8 through a joining layer (not illustrated). Similarly, the lead frame 15 is joined on the metallic circuit 9 through a joining layer (not illustrated). Adjacent metallic circuits 9 are electrically connected by the bonding wire 12. In FIG. 6, the bonding wire 12 and the metallic circuit 9 are joined in addition to the semiconductor device 13. The ceramic circuit substrate 8 to which the bonding wire 12 is connected is integrated by the resin mold 14, and thereby, the semiconductor module 11 is obtained. The semiconductor module 11 is not limited to this structure. For example, one of the bonding wire 12 and the lead frame 15 may be adopted. Further, multiple semiconductor devices 13, multiple bonding wires 12, and multiple lead frames 15 may be provided on the metallic circuit 9.

As the joining layer for joining the semiconductor device 13 or the lead frame 15, there are solder, a brazing material, and the like. It is preferable that the solder is lead-free solder. Further, the solder is a solder whose melting point is 450°C or less. The brazing material is a brazing material whose melting point is more than 450°C. Further, a brazing material whose melting point is 500°C or more is referred to as a high-temperature brazing material. As the high-temperature brazing material, there is a brazing material that contains Ag as a main component.

As for the semiconductor device 13, while the size has decreased, the amount of the heat generation from a chip has continued to increase. Therefore, in the ceramic circuit substrate 8 including the semiconductor device 13, the improvement in heat dissipation is important. Further, for the increase in the performance of the semiconductor module 11, multiple semiconductor devices 13 is mounted on the ceramic circuit substrate 8. When one device of the semiconductor devices 13 exceeds an intrinsic temperature, the temperature coefficient changes to a temperature coefficient on a minus side on which resistance is negative. This causes a phenomenon in which breakdown immediately occurs due to thermal runaway in which electric power concentratively flows. Consequently, the improvement in heat dissipation is effective.

The semiconductor module 11 can be used as a module in a PCU (Power Control Unit), an IGBT (Insulated Gate Bipolar Transistor), an IPM (Intelligent Power Module), or the like that is used for an inverter in an automobile (including an electric vehicle), an electric train, an industrial machine, an air conditioner, or the like. In the automobile industry, electric vehicles have been employed. The improvement in the reliability of the semiconductor module 11 directly leads to the safety of an automobile. A same goes for an electric train, an industrial machine, an air conditioner, or the like.

### (Sintered Silicon Nitride Substrate)

Next, a laser scribe method for a sintered silicon nitride substrate as the sintered ceramic substrate will be described. The laser scribe method for the sintered silicon nitride substrate is not particularly limited. For obtaining a silicon nitride scribe substrate as the scribe substrate 1 with high yield ratio, the following method may be adopted.

First, the sintered silicon nitride substrate is prepared. Particularly, in consideration of the whole heat dissipation of the ceramic circuit substrate 8 that is produced from the sintered silicon nitride substrate, it is preferable that the sintered silicon nitride substrate has a heat conductivity of 50 W/m·K or more and a three-point bending strength of 600 MPa or more.

When the metallic circuit 9 and the metallic radiator plate 10 are electrically connected, a silicon nitride scribe substrate including a through-hole is prepared. The silicon nitride scribe substrate in which the through-hole is provided may be obtained by sintering a compact in which a through-hole is provided, or may be obtained by providing a through-hole in the sintered silicon nitride substrate. In the case of a latter, a step of providing the through-hole in the sintered silicon nitride substrate is performed by laser processing or the like that is similar to cutting processing or laser scribe. The cutting processing is performed by hole making processing or the like with a drill or the like.

The sintered silicon nitride substrate is set on a precision processing table of a laser processing machine. The sintered silicon nitride substrate is irradiated with the laser, and the side scribe lines 3 and the corner scribe lines 4 are formed, so that the silicon nitride scribe substrate as the scribe substrate 1 is obtained. On this occasion, a dot having a predetermined size is formed based on the condition of the laser processing machine.

Next, in the before-joining dividing step ST4, stress is applied to the silicon nitride scribe substrate as the scribe substrate 1, and the silicon nitride scribe substrate 1 is divided along the scribe lines, so that silicon nitride substrates as one or multiple ceramic substrates 2 are produced.

Next, in the after-dividing joining step ST5, the metallic circuit 9 is joined to the silicon nitride substrate as the ceramic substrate 2. It is preferable that the joining between the silicon nitride substrate and the metallic circuit 9 is performed by the active metal joining method. In the active metal joining method, an active metal brazing material in which an active metal such as Ti is mixed is used. As the active metal brazing material, there is a mixture of Ti, Ag, and Cu, and for example, in the active metal brazing material, Ti is contained at 0.1 wt% or more and 10 wt% or less, Cu is contained at 10 wt% or more and 60 wt% or less, and the remnant is Ag. Further, as necessary, one or more kinds selected from In, Sn, Al, Si, C, and Mg may be added in the active metal brazing material, at 1 wt% or more and 15 wt% or less.

The paste of the active metal brazing material is made. In the paste, a brazing material component and an organic substance are mixed. The brazing material component needs to be evenly mixed. This is because the uneven distribution of the brazing material component causes unstable brazing and poor joining.

The active metal brazing material paste is applied to the silicon nitride substrate as the ceramic substrate 2. A copper plate as the metallic circuit 9 is disposed thereon. Next, a step of heating and joining this at 600°C or more and 900°C or less is performed. The heating step is performed in a vacuum or in a non-oxidizing atmosphere, as necessary. In the case of the vacuum, it is preferable that the heating step is performed at 1 × 10⁻² Pa or less. Further, as the non-oxidizing atmosphere, there are a nitrogen atmosphere and an argon atmosphere. By adopting the vacuum or the non-oxidizing atmosphere, it is possible to inhibit the oxidation of the joining layer. Thereby, the joining strength is improved.

The metallic circuit 9 to be joined may be a metallic circuit that has been previously processed in a pattern shape for circuit formation, or may be a single plate to which pattern processing has not been performed. In the case where the single plate is used, the single plate is processed in a pattern shape by performing etching processing, after joining. By this step, a silicon nitride metallic circuit plate as the ceramic circuit substrate 8 can be produced.

Next to the after-dividing joining step ST5, a step of joining the semiconductor device 13 and the like is performed. A joining layer is provided at a spot where the semiconductor device 13 is joined. As the joining layer, solder or a brazing material is preferable. The joining layer is provided, and the semiconductor device 13 is provided thereon. Further, as necessary, the lead frame 15 is joined through a joining layer. Further, as necessary, the bonding wire 12 is provided. Further, the semiconductor device 13, the lead frame 15, and the bonding wire 12 are provided to necessary numbers. The silicon nitride circuit substrate 8 with the semiconductor device 13, the lead frame 15, and the bonding wire 12 is integrated by the resin mold 14, and thereby, an interior is sealed.

In the above description, the ceramic circuit substrate 8 is produced by joining the metallic circuit 9 and the like to the ceramic substrate 2 after the division from the scribe substrate 1 (steps ST4 and ST5), but the embodiment is not limited to the case. For example, the ceramic circuit substrate 8 may be produced by joining the metallic circuit 9 and the like to the ceramic substrate 2 in the scribe substrate 1 before the division and dividing, along the scribe lines, the scribe substrate 1 to which the metallic circuit 9 and the like have been joined, by applying stress (steps ST4 and ST5). That is, the order of the division step for the scribe substrate 1 and the joining step for the metallic circuit 9 and the like does not matter.

### (Sintered Aluminum Nitride Substrate)

Next, a laser scribe method for a sintered aluminum nitride substrate as the sintered ceramic substrate will be described. First, the sintered aluminum nitride substrate is prepared. Particularly, in consideration of the whole heat dissipation of the ceramic circuit substrate 8, it is preferable that the sintered aluminum nitride substrate has a heat conductivity of 170 W/m·K or more and a three-point bending strength of 350 MPa or more. The laser scribe method for the sintered aluminum nitride substrate is not particularly limited. For obtaining an aluminum nitride scribe substrate as the scribe substrate 1 with high yield ratio, a same method as the above-described method for the silicon nitride scribe substrate is adopted.

### (Examples 1-18, Comparative Examples 1-2)

For each of examples and comparative examples shown in Table 1, 100 sintered ceramic substrates were prepared. The sintered ceramic substrates include sintered silicon nitride substrates, sintered aluminum nitride substrates, sintered aluminum oxide (alumina) substrates, and sintered Alusil (alumina zirconia) substrates. The sintered silicon nitride (Si₃N₄) substrate had a heat conductivity of 90 W/m·K and a three-point bending strength of 650 MPa. The sintered aluminum nitride (AlN) substrate had a heat conductivity of 170 W/m·K and a three-point bending strength of 300 MPa. The sintered aluminum oxide (Al₂O₃) substrate had a heat conductivity of 25 W/m·K and a three-point bending strength of 400 MPa. The sintered Alusil substrate had a heat conductivity of 25 W/m·K and a three-point bending strength of 650 MPa. In the examples and the comparative examples, the size of the front and back surfaces of the sintered ceramic substrate was 14 cm × 27 cm. In the examples and the comparative examples, the thickness of the sintered ceramic substrate was 0.32 mm in the case of the sintered silicon nitride substrate, and was 0.64 mm in the case of the sintered aluminum nitride substrate, the sintered aluminum oxide substrate, or the sintered Alusil substrate.

In the examples, in the laser processing step ST1, the side scribe lines 3 (shown in FIG. 1) were formed on the sintered ceramic substrate by laser processing. The jetting pressure of the assist gas jetted for discharging the molten material during the irradiation with the laser at the time of the formation of the side scribe lines 3 was 0.1 MPa (partial pressure of oxygen 0%). Thereafter, the corner scribe lines 4 having an identical shape and area were formed at the four corners of each ceramic substrate 2. The area (an average value of 100 scribe substrate 1) of the front surface of the C-surface portion 44 cut by one C-surface 43 of one ceramic substrate 2 shown in FIG. 2 is shown in Table 1.

The C-surface portion 44 means a portion of the removal portion 6 that corresponds to each ceramic substrate 2. For example, in the first removal portion 61, each of the areas of the front surfaces of the two C-surface portions 44 is 1/2 of the area of the front surface of the first removal portion 61. In the second removal portion 62, each of the areas of the front surfaces of the four C-surface portions 44 is 1/4 of the area of the front surface of the second removal portion 62. In the third removal portion 63, the area of the front surface of the one C-surface portion 44 is identical to the area of the front surface of the third removal portion 63.

The jetting pressure of the assist gas during the laser irradiation when the corner scribe lines 4 were formed is described as "jetting pressure" in Table 1. In the comparative examples 1 and 5-7, the jetting of the assist gas for discharging the molten material was not performed during the laser irradiation when the corner scribe lines 4 were formed. Further, the assist gas containing nitrogen gas as a base was used. The partial pressure of oxygen in the assist gas is described as "partial pressure of oxygen" in Table 1. In addition, under conditions about the comparative examples in Table 1, laser processing was performed to the sintered ceramic substrate, and the scribe substrate was produced.

**[Table 1]**

| | Type of Ceramic Sintered Substrate | Area of C-Surface Portion [mm²] | Partial Pressure of Oxygen [%] | Jetting Pressure [MPa] |
|---|---|---|---|---|
| Example 1 | Si₃N₄ | 10.0 | 0 | 0.5 |
| Example 2 | Si₃N₄ | 1.1 | 0 | 0.5 |
| Example 3 | Si₃N₄ | 20.0 | 0 | 0.5 |
| Example 4 | Si₃N₄ | 10.0 | 0 | 0.1 |
| Example 5 | Si₃N₄ | 10.1 | 0 | 1.0 |
| Example 6 | Si₃N₄ | 10.0 | 20 | 0.5 |
| Example 7 | AlN | 9.9 | 0 | 0.2 |
| Example 8 | AlN | 10.0 | 0 | 1.0 |
| Example 9 | Al₂O₃ | 10.0 | 0 | 0.2 |
| Example 10 | Al₂O₃ | 10.0 | 0 | 1.0 |
| Example 11 | Alusil | 10.0 | 0 | 0.2 |
| Example 12 | Alusil | 10.1 | 0 | 1.0 |
| Comparative Example 1 | Si₃N₄ | 1.0 | - | 0.0 |
| Comparative Example 2 | Si₃N₄ | 1.0 | 30 | 0.1 |
| Comparative Example 3 | Si₃N₄ | 0.0 | 30 | 0.1 |
| Comparative Example 4 | Si₃N₄ | 2.4 | 30 | 1.2 |
| Comparative Example 5 | AlN | 1.0 | - | 0.0 |
| Comparative Example 6 | Al₂O₃ | 1.0 | - | 0.0 |
| Comparative Example 7 | Alusil | 1.0 | - | 0.0 |

After the laser processing step ST1 and the removal step ST2, the external appearances of the 100 scribe substrates 1 in each example were examined, and for a scribe substrate 1 in which the removal portion 6 remained without being removed, the judgment of removal defect was made. Moreover, for each example, the ratio of removal defect scribe substrates to the 100 scribe substrates 1 was evaluated as a removal defect ratio [%]. Further, for each example, for a scribe substrate 1 in which a color change was recognized around the scribe lines 3, 4, the judgment of color-change defect was made, and a color-change defect ratio [%] was evaluated similarly. Further, for each example, for a scribe substrate 1 in which the scribe lines 3, 4 fell outside design tolerance, the judgment of dimension-accuracy defect was made, and a dimension-accuracy defect ratio [%] was evaluated similarly. The respective defect ratios are shown in Table 2. On the other hand, also in the case where laser processing was performed to the sintered ceramic substrate under the conditions about the comparative examples in Table 1, the removal defect ratio [%], the color-change defect ratio [%], the dimension-accuracy defect ratio [%] were evaluated similarly.

**[Table 2]**

| | Removal Defect Ratio [%] | Color-Change Defect Ratio [%] | Dimension-Accuracy Defect Ratio [%] |
|---|---|---|---|
| Example 1 | 0 | 0 | 0 |
| Example 2 | 0 | 0 | 0 |
| Example 3 | 0 | 0 | 0 |
| Example 4 | 1 | 0 | 0 |
| Example 5 | 0 | 0 | 1 |
| Example 6 | 0 | 1 | 0 |
| Example 7 | 2 | 0 | 0 |
| Example 8 | 0 | 0 | 1 |
| Example 9 | 2 | 0 | 0 |
| Example 10 | 0 | 0 | 1 |
| Example 11 | 2 | 0 | 0 |
| Example 12 | 0 | 0 | 1 |
| Comparative Example 1 | 18 | 45 | 0 |
| Comparative Example 2 | 9 | 16 | 0 |
| Comparative Example 3 | 20 | 19 | 0 |
| Comparative Example 4 | 37 | 20 | 9 |
| Comparative Example 5 | 17 | 41 | 0 |
| Comparative Example 6 | 19 | 0 | 0 |
| Comparative Example 7 | 19 | 0 | 0 |

As seen in Table 2, in the scribe substrates 1 produced under the conditions about the examples in Table 1, the removal defect did not occur, or the removal defect ratio was as small as 2% or less. This is because the removal portion 6 was properly removed by the jetting of the assist gas. In contrast, in the scribe substrates produced under the conditions about the comparative examples in Table 1, the removal defect frequently occurred, and the removal defect ratio was as large as 9% or more. Under the conditions in the comparative examples 1 and 5-7, the assist gas was not used, and therefore, the assist gas was not thrown against the removal portion 6, so that the removal portion 6 could not be removed. Under the conditions in the comparative examples 2-3, the pressure of the assist gas jetted during the laser irradiation was low, and therefore, a sufficient pressure was not applied to the removal portion 6, so that the removal portion 6 could not be removed. Under the condition about the comparative example 4, the pressure of the assist gas jetted during the laser irradiation was excessively high, the position of the scribe substrate was shifted, and the assist gas was not thrown against a necessary spot, so that the removal portion 6 could not be removed.

In the scribe substrate 1 produced under the conditions about the examples, the color-change defect did not occur, or the color-change defect ratio was as small as 1% or less. This is because the oxidization of the front surface of the scribe substrate 1 was prevented due to the low oxygen partial pressure. In contrast, in the scribe substrates produced under the conditions about the comparative examples 1-5, the color-change defect frequently occurred, and the color-change defect ratio was as large as 16% or more. The comparative examples 1-5 were scribe substrates in which nitride-type sintered ceramic substrates were used, and the assist gas was not used or was used at high oxygen partial pressures, so that the front surface of the scribe substrate was oxidized.

According to at least one embodiment described above, it is possible to efficiently produce the scribe substrate 1, the ceramic substrate 2, and the ceramic circuit substrate 8, with no defect, from a high-strength thin sintered ceramic substrate that has both heat dissipation and electric insulation and that includes front and back surfaces having a large size.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A production method for a ceramic scribe substrate including a ceramic substrate as an element, the production method comprising:
a laser processing step of forming a continuous through-groove as a scribe line and forming a removal portion surrounded by multiple scribe lines, by irradiating a front surface of a sintered ceramic substrate with a laser; and
a removal step of removing the removal portion by jetting an assist gas coaxially with the laser, during the irradiation with the laser.

2. The production method for the ceramic scribe substrate according to claim 1, wherein
a jetting pressure of the assist gas is 0.2 MPa or more and 1.0 MPa or less.

3. The production method for the ceramic scribe substrate according to claim 1 or 2, wherein
an area of a front surface of a C-surface portion of the removal portion per each ceramic substrate is 1.0 mm² or more and 20.0 mm² or less.

4. The production method for the ceramic scribe substrate according to claim 1 or 2, wherein
the sintered ceramic substrate is an aluminum nitride substrate or a silicon nitride substrate, and a partial pressure of oxygen contained in the assist gas is 20% or less.

5. The production method for the ceramic scribe substrate according to claim 1 or 2, wherein
in the removal step, the removal portion is removed by jetting the assist gas after the irradiation with the laser, in addition to during the irradiation with the laser.

6. The production method for the ceramic scribe substrate according to claim 1 or 2, wherein
in the removal step, the removal portion is removed by jetting the assist gas coaxially with the laser, during the irradiation with the laser when a corner scribe line of the plurality of the scribe lines is formed.

7. A production method for a ceramic substrate, the production method comprising:
the laser processing step and the removal step that are included in the production method for the ceramic scribe substrate according to claim 1; and
a before-joining dividing step of producing the ceramic substrate by applying stress to the ceramic scribe substrate after the removal step and dividing the ceramic scribe substrate along the plurality of the scribe lines.

8. A production method for a ceramic circuit substrate, the production method comprising:
the laser processing step, the removal step, and the before-joining dividing step in the production method for the ceramic substrate according to claim 7; and
an after-dividing joining step of producing the ceramic circuit substrate by joining a metallic circuit to the ceramic substrate.

9. A production method for a ceramic circuit substrate, the production method comprising:
the laser processing step and the removal step in the production method for the ceramic scribe substrate according to claim 1;
a before-dividing joining step of joining a metallic circuit to the ceramic scribe substrate after the removal step; and
an after-joining dividing step of producing the ceramic circuit substrate by applying stress to the ceramic scribe substrate to which the metallic circuit has been joined and dividing the ceramic scribe substrate along the multiple scribe lines.
